# EUROPEAN PATENT APPLICATION

(11) **EP 2 116 629 A1**
(43) Date of publication of application: **11.11.2009**
(21) Application number: 08711628.1
(22) Date of filing: 20.02.2008
(51) Int. Cl.: C23C 14/24, C23C 14/12, C23C 14/28, H01L 51/50, H05B 33/10

(54) **DEPOSITION SOURCE, DEPOSITION APPARATUS AND METHOD FOR FORMING ORGANIC THIN FILM**

(30) Priority: 28.02.2007 JP 2007049906
(71) Applicant: Ulvac, Inc., Chigasaki-shi, Kanagawa 253-8543 (JP)
(72) Inventor: NEGISHI, Toshio, Chigasaki-shi Kanagawa 253-8543 (JP)
(74) Representative: Körber, Wolfhart
(86) International application number: PCT/JP2008/052822
(87) International publication number: WO 2008/105287

(57) **Abstract**

A vapor deposition apparatus capable of forming an organic thin film having a good film quality is provided. The vapor deposition apparatus 1 of the present invention possesses an evaporating chamber 15 and a vapor deposition case 21; and the vapor deposition case 21 is connected with the evaporating chamber by a small hole 38. Since a vapor deposition material 16 is fed into the evaporating chamber 15 based on an amount necessary for each substrate, a large amount of the vapor deposition material 16 is not heated for a long time period. Since the vapor deposition material 16 is evaporated in the evaporating chamber 15, no liquid drops reach a substrate 6 even during bumping. When the vapor deposition material 16 is evaporated by irradiation with a laser beam, the vapor deposition material 16 can be less chemically denatured.

## Description

### TECHNICAL FIELD

The present invention generally relates to a technical field of organic thin films; and more particularly, the invention relates to a technique for producing organic thin films having a good quality.

### BACKGROUND ART

The organic EL element is one of the recently most noticeable display elements, and has excellent characteristics of high brightness and a high response speed. The organic EL element is provided with light-emitting areas, on a glass substrate, in which colors are developed in three different colors of red, green and blue. In the light-emitting area, an anode electrode film, a hole-injecting layer, a hole transporting layer, a light-emitting layer, an electron-transporting layer, an electron-injecting layer and a cathode electrode film are laminated in this order. Colors are developed in red, green or blue depending upon color-fixing agents added into the light-emitting layers.

The hole-transporting layer, the light-emitting layer, the electron-transporting layer, etc. are generally made of organic materials; and vapor deposition apparatuses are widely used in order to form films of such organic materials.

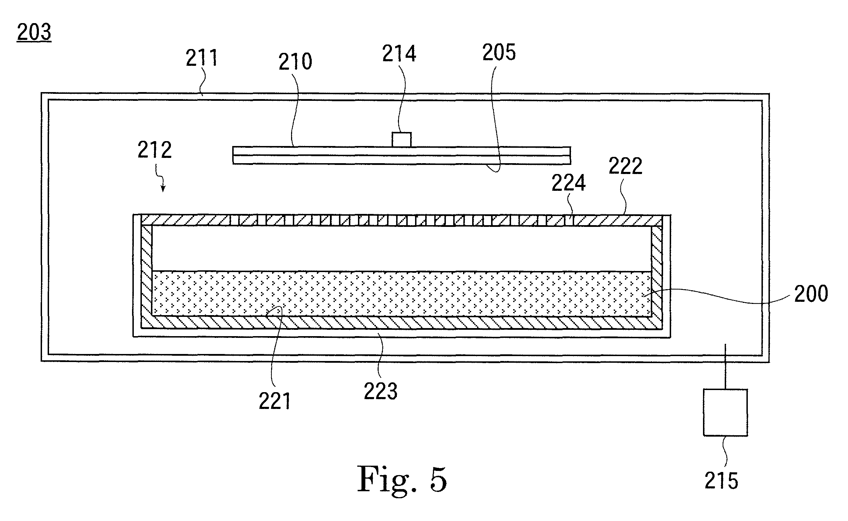

In Fig. 5, a reference numeral 203 denotes a vapor deposition apparatus in the prior art, and a vapor deposition case 212 is arranged inside a vacuum chamber 211. The vacuum deposition container 212 has a case body 221, and an upper portion of the case body 221 is closed by a lid 222 with one or plural discharge openings 224.

A powdery organic vapor deposition material 200 is placed inside the vapor deposition case 212.

A heater 223 is arranged at a side face and a bottom face of the vapor deposition case 212. When the interior of the vacuum chamber 211 is evacuated to a vacuum state by a vacuum evacuation system 215 and heat is generated by the heater 223, the vapor deposition case 212 is heated, and the organic vapor deposition material 200 inside the vapor deposition case 212 is heated.

When the organic vapor deposition material 200 is heated to a temperature not less than the vaporizing temperature, a vapor of the organic material is filled inside the vapor deposition case 212, and discharged into the vacuum chamber 211 through the discharge openings 224.

A substrate-transporting unit 214 is arranged above the discharge openings 224. When a substrate 205 is held by a holder 210 and the substrate-transporting unit 214 is moved, the substrate 205 passes a position immediately above the discharge openings 224, so that the vapor of the organic material discharged through the discharge openings 224 reaches a surface of the substrate 205, thereby forming a hole-injecting layer, the hole-transporting layer or the like.

When the substrates 205 are passed above the discharge openings 224 one by one while the vapor of the organic material is being discharged, organic thin films can be successively formed on the plural substrates 205.
Patent Document JP-A 2003-96557

### DISCLOSURE OT THE INVENTION

### PROBLEMS TO BE SOLVED BY THE INVENTION

However, in order to form the films on the plural substrates 205 as discussed above, a large amount of the organic vapor deposition material 200 needs to be placed inside the vapor deposition case 212. In an actual producing site, the films are continuously formed for 120 hours or longer, while the vapor deposition material is being heated at 350° C to 450° C. Consequently, the organic vapor deposition material 200 inside the vapor deposition case 212 is exposed to the high temperature for a long time period, so that it is denatured through reaction with moisture inside the vapor deposition case or decomposed progressively through heating. Thus, the organic vapor deposition material 200 is deteriorated as compared to a state in a heating initial stage.

If the organic vapor deposition material 200 bumps upon heating, liquid drops of a melt of the organic vapor deposition material 200 are discharged. Thus, there is a problem that since the bumping occurs immediately under the discharge openings 224, a part of the liquid drops pass the discharge openings 224, and if the liquid drops reach the substrate 205, they are mixed into a formed film resulting in the film quality being damaged.

### MEASURES TO SOLVE THE PROBLEM

In order to solve the above-explained problem, the present invention is directed to a vacuum deposition source, which has an evaporating chamber in which a vapor of a vapor deposition material is generated, a vapor deposition case having discharge openings for discharging the vapor of the vapor deposition material, a hole connecting an interior space of the vapor deposition case with an interior space of the evaporating chamber, a feeding unit connected to the evaporating chamber and adapted to feed a vapor deposition material into the interior of the evaporating chamber, a heater for heating and evaporating the vapor deposition material fed into the evaporating chamber.

The present invention is directed to a vapor deposition source, wherein the evaporating chamber is provided with a window for transmitting a laser beam, and the heater is configured so as to irradiate the laser beam into the interior of the evaporating chamber through the window.

The present invention is directed to a vapor deposition source, wherein the feeding unit has a feeding chamber in which the vapor deposition material is placed, a pipe having one end connected to the feeding chamber and the other end connected to the evaporating chamber, a rotary shaft inserted into the pipe and a rotating means for rotating the rotary shaft around a central axis, and a spiral groove being formed at a peripheral face of the rotary shaft.

The present invention is directed to a vapor deposition source, which has a heater for heating the vapor deposition case.

The present invention is directed to a vapor deposition apparatus, having a vacuum chamber and a vacuum deposition source, the vacuum deposition source having an evaporating chamber for generating a vapor of a vapor deposition material therein, a vapor deposition case with discharge openings for discharging a vapor of the vapor deposition material, a hole connecting an interior space of the vapor deposition case with an interior space of the evaporating chamber, a feeding unit connected to the evaporating chamber and adapted to feed the vapor deposition material into the interior of the evaporating chamber, and a heater for heating and evaporating the vapor deposition material fed into the evaporating chamber, and the vapor deposition case is provided with discharge openings connecting an interior space with an interior space of the vacuum chamber.

The present invention is directed to a vacuum deposition apparatus, wherein a carrier mechanism is arranged inside the vacuum chamber, the carrier mechanism being configured to hold an object to form a film thereon and passing the object at a place opposed to the discharge openings of the vapor deposition case.

The present invention is directed to a method for forming an organic thin film including discharging a vapor of an organic material into an interior of a vacuum chamber in order to form a thin film of the organic material on a surface of a substrate arranged inside the vacuum chamber, wherein the method includes the step of discharging the vapor into the interior of the vacuum chamber through discharge openings provided in the vapor deposition case.

The present invention is directed to a method for forming the organic thin film, wherein the vapor is generated by irradiating a laser beam to the organic material fed into the evaporating chamber.

The present invention is constructed as discussed above, wherein the evaporation material is not evaporated in the vapor deposition case with the discharge openings but evaporated in the evaporating chamber adjacent to the vapor deposition case. Therefore, even if the bumping occurs when the vapor deposition material is evaporated, no liquid drops reach the substrate, so that the film quality of the thin film grown on the surface of the substrate is not deteriorated. When the evaporating chamber is connected with the vapor deposition case by a slender space (such as, the pipe or the like), the distance between the evaporating chamber and the vapor deposition case is longer, so that the liquid drops will not leak.

According to the method of evaporating the vapor deposition material by irradiating the laser beam, the vapor deposition material is less chemically denatured as compared to a heating method (such as, a resistance heating or the like).

Therefore, the vapor deposition method using the laser beam is particularly suitable for evaporating the material which is likely to be chemically denatured when heating, just like with an organic EL material (an electron-transferring material, a light-emitting material, an electron-transferring material, etc.). Thus, the organic EL material is less denatured, so that an organic EL device having a high light emission amount can be produced.

Since the laser beam can even evaporate a polymer with no chemical denaturing, a thin film of the polymer, which has been conventionally formed by an ink injection method, a screen printing method or a spin coating method, can be formed by the vapor deposition method.

When the vapor deposition material-feeding unit is connected to the evaporating chamber and an amount necessary for forming a predetermined number of films is fed each essential time, a large amount of the vapor deposition material is not heated for a long time even if the films are continuously formed on a number of the substrates; and thus, the vapor deposition material is not denatured.

### EFFECTS OF THE INVENTION

Since the vapor deposition material is not exposed to a high temperature for a long time period, it is not decomposed or denatured. Consequently, the thin film, which does not differ from the vapor deposition material in chemical composition, can be formed; and the organic EL device having a high emission amount can be produced.

### BRIEF DESCRIPTION OF THE DRAWINGS

Fig. 1 is a perspective view for illustrating a vapor deposition apparatus as a first embodiment of the present invention.
Fig. 2 is a schematically sectional view for illustrating the interior of the vapor deposition apparatus.
Fig. 3 is a schematically sectional view for illustrating a vapor deposition apparatus as a second embodiment of the present invention.
Fig. 4 is a schematically sectional view for illustrating a vapor deposition apparatus as a third embodiment of the present invention.
Fig. 5 shows the vapor deposition apparatus in the prior art.

### EXPLANATION OF REFERENCE NUMERALS

1, 50, 70 --- vapor deposition apparatus, 2 --- heater (laser irradiating device), 6 --- object to form a film thereon(substrate), 12 --- vacuum chamber, 15 --- evaporating chamber, 21 --- vapor deposition case, 25 --- partition member, 30 --- feeding unit

### BEST MODE FOR CARRYING OUT THE INVENTION

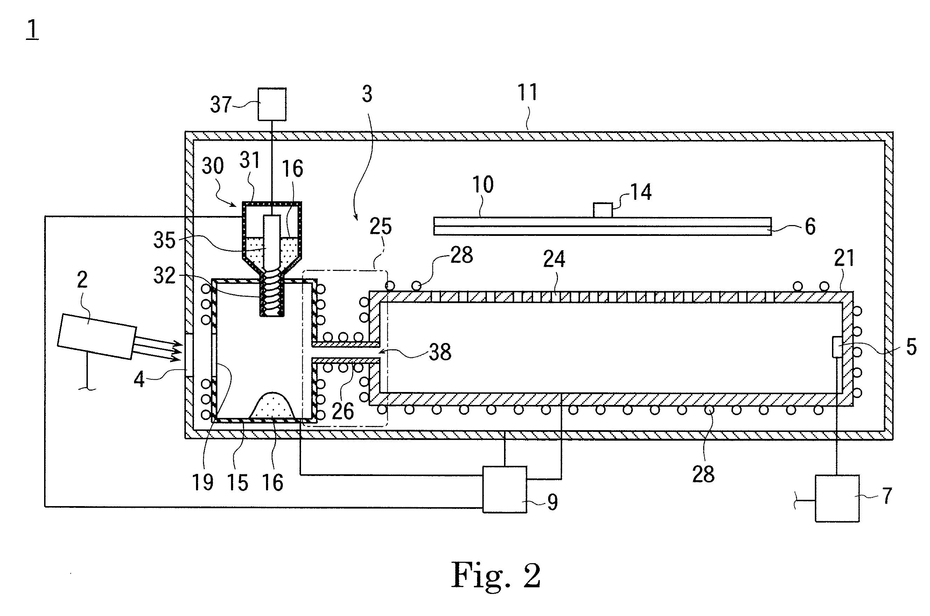

In the sectional view of Fig. 2, a reference numeral 1 generally denotes an embodiment of the present invention, i.e., a vapor deposition apparatus according to the first embodiment of the present invention.

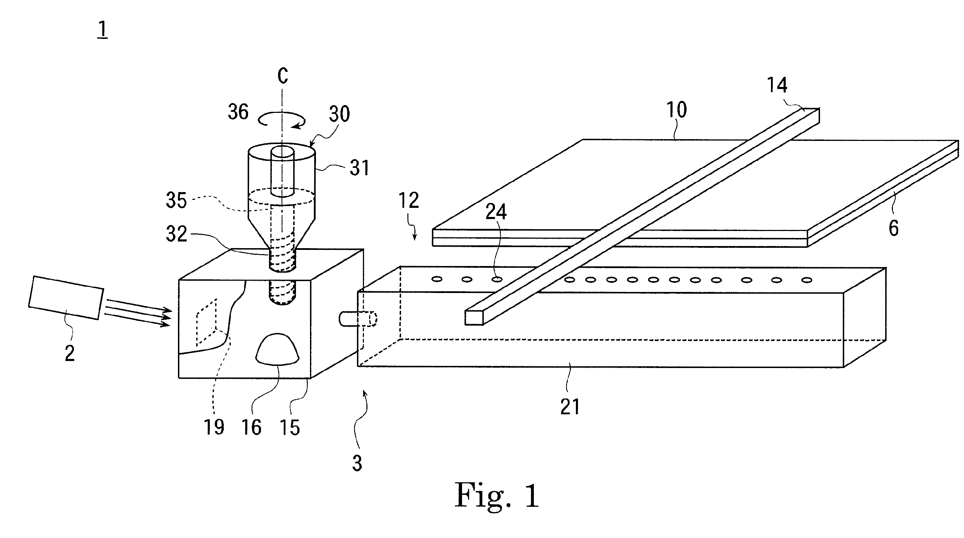

This vapor deposition apparatus 1 comprises a vacuum chamber 11 and a vapor deposition source 3. (In Fig. 1, the vacuum chamber 11 is omitted. )

A vacuum evacuating system 9 is connected to the vacuum chamber 11; and when the vacuum evacuating system 9 is operated, the interior of the vacuum chamber 11 is evacuated to a vacuum state.

The vacuum deposition source 3 comprises a vacuum deposition casing 21, an evaporating chamber 15 and a feeding unit 30. The vapor deposition case 21 is arranged inside the vacuum chamber 11. The vapor deposition case 21 is provided with a plurality of discharge openings 24 in a row. As will be discussed later, when a vapor deposition material 16 fed from the feeding unit 30 is evaporated inside the evaporating chamber 15, the vapor is introduced into the vapor deposition case 21, and the vapor of the vapor deposition material is discharged into the vacuum chamber 11 through each of the discharging openings 24.

A substrate carrier mechanism 14 is arranged inside the vacuum chamber 11. A holder 10 is attached to the substrate carrier mechanism 14. The substrate as an object, onto which a film is formed is held by the holder 10 in order to move inside the vacuum chamber 11; thus, the substrate is passed through a position opposed to the discharging openings 24 in a direction orthogonal to a direction in which the discharging openings 24 are in a straight line.

The width of the substrate is smaller than an area in which the discharging openings 24 are arranged; the vapor of the vapor deposition material discharged into the interior of the vacuum chamber 11 through the discharging openings 24 uniformly reaches a surface of the substrate; and a thin film of the vapor deposition material is formed. A mask may be disposed between the substrate and the discharging openings 24 so that a thin film may only be formed on a predetermined area of the surface of the substrate.

Next, the vacuum deposition source 3 will hereinafter be explained in detail.

The feeding unit 30 comprises a feeding chamber 31, a pipe 32 and a rotary shaft 35. The feeding chamber 31 is arranged above the evaporating chamber 15.

The pipe 32 is inserted, in a gas-tightly manner, through a ceiling of the evaporating chamber 15, and its lower end is exposed inside the evaporating chamber 15, while the upper end is connected to the interior of the feeding chamber 31.

The diameter of the feeding chamber 31 is larger than that of the pipe 32, and an upper end opening of the pipe 32 is exposed at a bottom face of the feeding unit 31.

The rotary shaft 35 is inserted into the pipe 32 so that its upper end may be projected upwardly from the connecting portion between the feeding unit 31 and the pipe 32.

The portion of a peripheral face of the rotary shaft 35, which is above the lower end of the pipe 32, is provided with a spiral groove on at least a position above the connecting portion between the feeding chamber 31 and the pipe 32. Accordingly, when the vapor deposition material 16 collects on the bottom face of the feeding unit 31, it contacts the groove.

The vapor deposition material 16 to be used in this vapor deposition apparatus 1 is a powder. A projection between the grooves of the rotary shaft 35 contacts an inner wall face of the pipe 32, or a gap between the projection and the inner wall portion is not more than particle diameters of the vapor deposition material 16, so that the vapor deposition material 16 may not fall in a state such that the rotary shaft 35 stays still.

A rotating unit 37 is arranged outside the vacuum chamber 11. The rotating shaft 35 is connected to the rotating unit 37. It is configured that when a power of the rotating unit 37 is transmitted to the rotary shaft 35, the rotary shaft 35 rotates around a central axis C, without ascending or descending, while it is kept inserted inside the pipe 32.

The rotating direction at this time is a direction in which the rotary shaft 35 moves upwardly based on the assumption that the rotary shaft 35 is screwed into a solid. Thus, the vapor deposition material 16 therearound is pushed downwardly by a counteraction of a force applied to the rotary shaft 35.

The lower end of the groove is connected to an interior space of the evaporating chamber 15, so that when the vapor deposition material 16 is pushed downwardly, it drops into the interior of the evaporating chamber 15.

A dropping amount of the vapor deposition material 16, when the rotary shaft 35 is rotated at one turn, is preliminarily grasped (for example, 0.01g per turn), so that when the rotary shaft 35 is rotated by the number of rotations and meeting the necessary amount, the necessary amount of the vapor deposition material 16 can be fed into the evaporating chamber 15.

The evaporating chamber 15 is provided with a transparent window 19. In this embodiment, the evaporating chamber 15 is positioned inside the vacuum chamber 11, and a window 4 is provided in a side wall of the vacuum chamber 11 at a place opposed to the window 19.

A laser irradiator 2 as a heater is arranged outside the vacuum chamber 11, and a laser beam irradiated by the laser irradiator 2 passes through the windows 4 and 19, and is irradiated to the vacuum deposition material 16 inside the vacuum chamber 15 in order to generate the vapor of the vacuum deposition material 16 inside the evaporating chamber 15.

An inner space defined by the evaporating chamber 15 and the vapor deposition case 21 is partitioned by a partition member 25, and the interiors of the vacuum chamber 15 and the vapor deposition case 21 are connected together by means of a small hole (hole) 38 provided in the partition member 25. The vapor generated in the evaporating chamber 15 moves into the vapor deposition case 21 through the small hole 38, and is discharged into the vacuum chamber 11 through the discharge openings 24.

Accordingly, a face of the evaporating chamber 15 and a face of the vapor deposition case 21 are arranged so as to oppose each other, while a pipe 26 is provided between the evaporating chamber 15 and the vapor deposition case 21, and the interior spaces of the evaporating chamber 15 and the vapor deposition case 21 are connected by the pipe 26.

Therefore, the partition member 25 is made up of mutually opposed wall faces of the evaporating chamber 15 and the vapor deposition case 21 and the wall face of the pipe 26, and the small hole 38 is made up of a smallest portion of the inner space of the pipe 26. In this embodiment, the pipe 26 has a uniform inner diameter (for example, a stainless tube having an inner diameter of 1mm), and an arbitrary portion of the interior of the pipe 26 is the small hole 38.

A heater 28 is provided on at least around the small hole (pipe 26) in the partition member 25. In this embodiment, the heater 28 is also attached to the evaporating chamber 15 and the vapor deposition case 21; and when the evaporating chamber 15, the vapor deposition case 21 and the pipe 26 are heated to a temperature not causing the deposition of the vapor by passing electric current through the heater 28, the vapor moves from the evaporating chamber 15 into the vapor deposition case 21 through the small hole 38 without the deposition of the vapor.

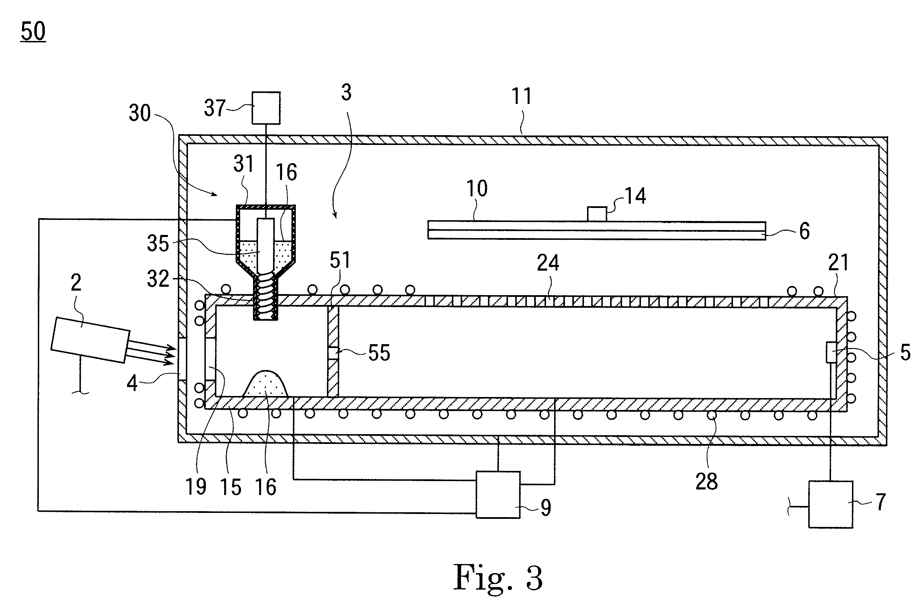

Meanwhile, neither the partition member 25 nor the small hole 38 is particularly limited, and as in a vacuum deposition apparatus 50 as a second embodiment shown in Fig. 3, the vapor deposition case 21 and the evaporating chamber 15 may be partitioned by a single wall 51. This wall may be taken as a partition member, and a through-hole 55 may be formed in the wall 51 as the small hole.

Next, steps of forming an organic thin film by using the vapor depositing apparatus 1 according to the present invention will be explained.

In the embodiments, the vacuum evacuating system 9 is connected to the vacuum chamber 11, the evaporating chamber 15, the vapor deposition case 21 and the feeding chamber 31, respectively. After vacuum atmospheres are formed at predetermined pressures by respectively evacuating the vacuum chamber 11, the evaporating chamber 15, the vapor deposition case 21 and the feeding chamber 31 to a vacuum state; and the vacuum atmospheres are formed at the predetermined pressures, the vacuum evacuation is stopped for the evaporating chamber 15, the vapor deposition case 21 and the feeding chamber 31, while the vacuum evacuation of the vacuum chamber 11 is continued.

For example, an organic material for an organic EL element (an electron-transferring material, an electron-generation material, a light-emitting material or the like) is preliminarily received as the vapor deposition material 16 in the feeding chamber 31.

An amount of the vapor deposition material 16 required to form a film for a single substrate is preliminarily grasped. While the vacuum evacuation of the vacuum chamber 11 is being continued, that amount of the vapor deposition material 16 required to form a film for one or more substrate is fed from the feeding unit 30 to the evaporating chamber 15, the evaporating chamber 15, the pipe 26 and the vapor deposition case 21 are kept, by the heater, at a temperature not causing the deposition of the vapor of the vapor deposition material 16 (for example, 150°C to 450°C), and the vapor deposition material 16 is evaporated by the irradiation of the laser beam.

The interior space of the evaporating chamber 15 is smaller than that of the vapor deposition case 21. When the vapor deposition material 16 evaporates and the interior of the evaporating chamber 15 is filled with the vapor of the vapor deposition material 16, the pressure of the evaporating chamber 15 becomes higher than that of the vapor deposition case 21, and the vapor moves into the vapor deposition case 21 due to the pressure difference.

Since the vacuum chamber 11 is set to a vacuum atmosphere of a predetermined pressure (for example, 10⁻⁷ Torr) through the continuous vacuum evacuation thereof, the vapor is drawn out from the vapor deposition case 21 into the vacuum chamber 11. Thus, the inner pressure of the vapor deposition case 21 is always lower than that of the evaporating chamber 15.

Since the interior space of the evaporating chamber 15 and the interior space of the vapor deposition case 21 are connected by the small hole 38 smaller than the partition member 25 as discussed above, the pressure difference between the evaporating chamber 15 and the vapor deposition case 21 becomes greater.

A vacuum gauge 5 is disposed inside the vapor deposition case 21. The vacuum gauge 5 and the laser irradiator 2 are respectively connected to a control unit 7. A target pressure is preliminarily set in the control unit 7, the pressure inside the vapor deposition case 21 is determined based on a signal fed from the vacuum gauge 5, and the evaporating amount of the vapor deposition material 16 is increased or decreased by changing the irradiating time period, the number of pulses, etc. of the laser irradiator 2 so that the pressure of the vapor deposition case may be the target pressure.

The size of the small hole 38 is set such that when the pressure inside the vapor deposition case 21 reaches the target pressure, the pressure inside the evaporating chamber 15 may be in a predetermined range. For example, when the target pressure is 10⁻⁴ Torr, the pressure inside the vacuum chamber 15 is 10⁻³ Torr to 10⁻²Torr.

The substrate 6 is held by the holder 10 in a state such that a surface on which a film is to be formed is directed downwardly, the pressure inside the vapor deposition case 21 is stabilized at the target pressure, the discharge amount of the vapor through the discharging openings 24 is stabilized, then the substrate 6 is moved to pass the position (film-forming position) opposed to the discharging openings 24, and an organic thin film is consequently formed on the surface of the substrate 6.

After a predetermined number of the substrate(s) 6 has (have) been passed through the film-forming position but before a succeeding substrate 6 reaches the film-forming position, the rotary shaft 35 is rotated by a predetermined number of rotations so that an amount of the vapor deposition material 16 required to form a predetermined number of films may be fed from the feeding unit 30. The feed amount at this time may be for a single substrate or for a plurality of substrates.

After the feeding of the predetermined feed amount of the vapor deposition material 16 is terminated, an organic thin film is formed by moving a fresh substrate 6 to the film-forming position. When the feeding of the vapor deposition material 16 and the film formation for the predetermined number of the substrates are repeated, a number of the substrates 6 can be continuously processed. In this case, the same amount of the vapor deposition material 16 may be fed every time or the feed amount may be changed.

Since the necessary amount of the vapor deposition material 16 is fed into the evaporating chamber 15 depending upon the need, a large amount of the vapor deposition material 16 is not heated over a long time period unlike the prior art, so that the vapor deposition material 16 is not deteriorated.

Although the case where the laser irradiator 2 is used to heat the vapor deposition material 16 has been explained, the present invention is not limited thereto. As the heater, a unit for heating the vapor deposition case 21 may be used. Such unit for heating may be a resistance heat generator for generating heat through current passage, a unit for heating the vapor deposition case 21 by the electromagnetic induction, a unit for heating the vapor deposition case 21 by irradiation of infrared rays, a unit for heating the vapor deposition case 21 by heat conduction of a heated heat medium or a unit for heating based on a Peltier effect, etc.

The laser beam is particularly preferable because it can evaporate not only inorganic materials but also organic materials (such as, monomers, oligomers, polymers, etc.) and furthermore, changes in the chemical composition of the vapor deposition material is small during evaporation.

Further, since a denatured product of the vapor deposition material 16 or an impurity differ from the target compound before denaturing in terms of the absorption wavelength, a thin film having a smaller mixed amount of the denatured product or the impurity can be formed by selectively evaporating only the target compound when a laser beam having a wavelength that is easily absorbed into the target compound is selected, even if a part of the vapor deposition material 16 is denatured or the impurity is mixed.

When a variable type in which the wavelength of the laser beam is varied is used as the laser irradiator 2, the wavelength of the laser beam to be discharged can be selected depending upon the absorption wavelength of the vapor deposition material 16, so that the vapor deposition apparatus 1 of the present invention can be used to form films of a variety of the vapor deposition materials 16.

Although the wavelength of the laser beam is not particularly limited, the wavelength is 680nm to 10.6µm if the vapor deposition material 16 is a polymer. The laser irradiator 2 is, for example, a CO2 laser having an aperture of 10µm to 20µm.

In the above embodiments, the organic thin films are formed by the vapor deposition apparatus of the present invention. The vapor deposition apparatus of the present invention is suitable for the producing method in which the vapor deposition material, which would be deteriorated by heating for a long time period, is evaporated in the vacuum atmosphere and thin films are successively formed on a plurality of objects on which the films are to be formed. The vapor deposition material of which the vapor is generated in the vacuum chamber 15 is not limited to the organic compounds. In summary, the vapor deposition apparatus of the present invention can be used not only when a thin film of the organic compound is formed, but also used for the formation of an inorganic thin film or a thin film of a composite material.

The evaporating chamber 15 and the feeding unit 30 can be arranged outside of the vacuum chamber 11. In this case, the window 4 need not be provided for the vacuum chamber 11.

Furthermore, the number of the evaporating chamber(s) 15 to be connected to a single vapor deposition case 21 is not particularly limited, and it may be that a plurality of the evaporating chambers 15 are connected to a single vapor deposition case 21 via small holes 38 so that the vapor may be fed from the plural evaporating chamber 15 into the vapor deposition case 21. In this case, the vapor of the same vapor deposition material 16 may be fed from each of the evaporating chambers 15, or vapors of different vapor deposition materials 16 may be fed. When the vapors of the different vapor deposition materials 16 are simultaneously fed, a thin film made of two or more kinds of the vapor deposition materials 16 is formed.

Although the case in which the vacuum evacuating system 9 is connected to both the evaporating chamber 15 and the vapor deposition case 21 has been explained above, the present invention is not limited thereto. When the vacuum evacuation system 9 is connected only to the vacuum chamber 11 and the interior of the vacuum chamber is evacuated to a vacuum state, the interior of the vapor deposition case 21 can be evacuated to a vacuum state through the discharging openings 24; and further, the interior of the evaporating chamber 15 can be evacuated to the vacuum state through the small hole 38. In addition, either one of the evaporating chamber 15 and the vapor deposition case 21 can be connected to the vacuum evacuating system.

Although explanation has been made on the apparatus in which the discharging openings 24 are directed vertically and upwardly, and the substrate is transported in a state such that the film-forming face is directed downwardly, the invention is not limited thereto.

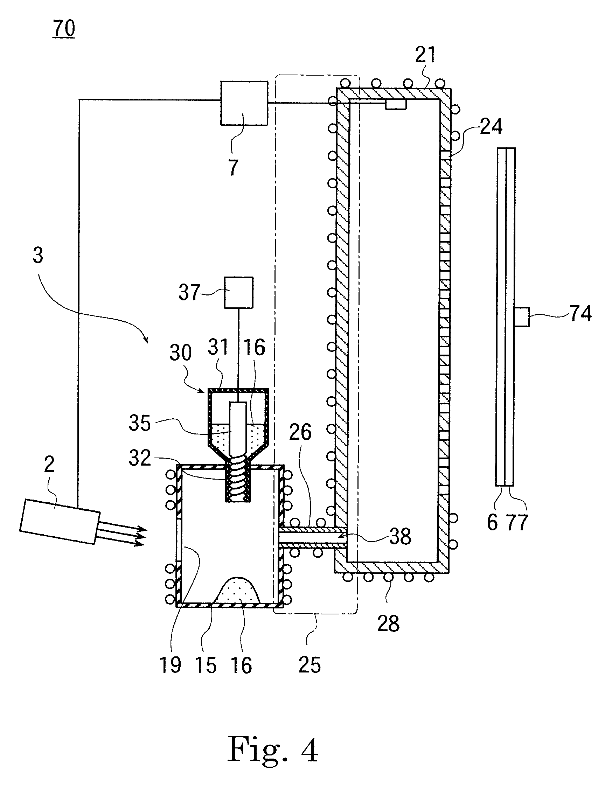

For example, as in a third embodiment of the vapor deposition apparatus shown by reference numeral 70 in Fig. 4, a slender vapor deposition case 21 may be arranged in a state such that its longitudinal direction is directed vertically and downwardly. In the vapor deposition apparatus 70, the same reference numerals are provided for the corresponding members of the vapor deposition apparatus 1 in Figs. 1 and 2, and explanation thereof is omitted.

A substrate carrier mechanism 74 can transfer a substrate 6 held by a holder 77 in a state such it is directed vertically, the substrate 6 is passed through a position opposed to the discharging openings 24, and a thin film is formed on a surface of the substrate 6 with the vapor discharged through the discharging openings 24.

## Claims

1. A vacuum deposition source, comprising:
an evaporating chamber in which a vapor of a vapor deposition material is generated;
a vapor deposition case having discharge openings for discharging the vapor of the vapor deposition material;
a hole connecting an interior space of the vapor deposition case with an interior space of the evaporating chamber;
a feeding unit connected to the evaporating chamber, wherein the feeding unit feeds the vapor deposition material into the interior of the evaporating chamber; and
a heater for heating and evaporating the vapor deposition material fed into the evaporating chamber.

2. The vapor deposition source as set forth in claim 1, wherein
the evaporating chamber is provided with a window for transmitting a laser beam, and
the heater is configured to irradiate the laser beam into the interior of the evaporating chamber through the window.

3. The vapor deposition source as set forth in claim 1, wherein
the feeding unit comprises a feeding chamber in which the vapor deposition material is placed, a pipe having one end connected to the feeding chamber and the other end connected to the evaporating chamber, a rotary shaft inserted into the pipe, and a rotating means for rotating the rotary shaft around a central axis,
wherein a peripheral face of the rotary shaft has a spiral groove.

4. The vapor deposition source as set forth in claim 1, further comprising a heater for heating the vapor deposition case.

5. A vapor deposition apparatus, comprising
a vacuum chamber and a vacuum deposition source,
wherein the vacuum deposition source comprises;
an evaporating chamber for generating a vapor of a vapor deposition material therein,
a vapor deposition case with discharge openings for discharging the vapor of the vapor deposition material,
a hole connecting an interior space of the vapor deposition case with an interior space of the evaporating chamber,
a feeding unit connected to the evaporating chamber and feeds the vapor deposition material into the interior of the evaporating chamber, and
a heater for heating and evaporating the vapor deposition material fed into the evaporating chamber, and
wherein the vapor deposition case is provided with discharge openings connecting an interior space with an interior space of the vacuum chamber.

6. The vacuum deposition apparatus, as set forth in claim 5, wherein a carrier mechanism is arranged inside the vacuum chamber, the carrier mechanism holds an object to form a film thereon and passes the object at a place opposed to the discharge openings of the vapor deposition case.

7. A method for forming an organic thin film, which is formed by discharging a vapor of an organic material into an interior of a vacuum chamber to form a thin film of the organic material on a surface of a substrate arranged inside the vacuum chamber, the method comprising the step of:
discharging the vapor into the interior of the vacuum chamber through discharge openings provided in the vapor deposition case.

8. The method for forming the organic thin film as set forth in claim 7, wherein the vapor is generated by irradiating a laser beam to the organic material fed into the evaporating chamber.
